# EUROPEAN PATENT SPECIFICATION

(11) **EP 4 207 313 B1**
(45) Date of publication and mention of the grant of the patent: **11.11.2026**
(21) Application number: 21877035.2
(22) Date of filing: 09.10.2021
(51) Int. Cl.: H10K 39/15, H10K 30/86, H10K 85/50, H10K 30/40, H10F 10/19, H10K 71/16, H10K 30/57

(54) **LAMINATED TANDEM SOLAR CELL AND METHOD FOR FABRICATION THEREOF**
LAMINIERTE TANDEM SOLARZELLE UND VERFAHREN ZU IHRER HERSTELLUNG
CELLULE SOLAIRE TANDEM STRATIFIÉE ET SON PROCÉDÉ DE FABRICATION

(30) Priority: 09.10.2020 CN 202011073513
(43) Date of publication of application: 05.07.2023
(73) Proprietor: Longi Green Energy Technology Co., Ltd., Xi'an, Shaanxi 710100 (CN)
(72) Inventor: XU, Chen, Shaanxi 710100 (CN)
(74) Representative: Loo, Chi Ching
(86) International application number: PCT/CN2021/122897
(87) International publication number: WO 2022/073518

(56) References cited:
- WO-A1-2018/150203
- CN-A- 105 679 941
- CN-A- 110 400 879
- CN-A- 110 690 301
- CN-A- 112 259 686
- US-A1- 2016 190 377
- US-A1- 2018 151 304
- CHEN YU ET AL: "Multilayer Cascade Charge Transport Layer for High-Performance Inverted Mesoscopic All-Inorganic and Hybrid Wide-Bandgap Perovskite Solar Cells", vol. 4, no. 10, 4 August 2020 (2020-08-04), XP093194563, ISSN: 2367-198X, Retrieved from the Internet <URL:https://onlinelibrary.wiley.com/doi/full-xml/10.1002/solr.202000344> DOI: 10.1002/solr.202000344
- ARNOLD T. ET AL: "X-ray spectroscopic study of the electronic structure of CuCrO2", PHYSICAL REVIEW B, vol. 79, no. 7, 1 February 2009 (2009-02-01), US, XP093194539, ISSN: 1098-0121, DOI: 10.1103/PhysRevB.79.075102

## Description

### TECHNICAL FIELD

The present disclosure relates to the technical field of photovoltaics and, more particular, to a tandem cell and a manufacturing method thereof.

### BACKGROUND

Organic-inorganic hybrid perovskite solar cells, as a new type of high-efficiency and low-cost solar cells, have been widely concerned all over the world. In just a few years, photoelectric conversion efficiency of perovskite cells has rapidly climbed from 3.8% in 2009 to over 25%, which is close to that of commercial silicon-based solar cells.

In order to further improve conversion efficiency of photovoltaic cells, a plurality of solar cells with different band gaps may be connected in series with a tunneling composite layer. A perovskite solar cell with a wide band gap may be used as a top cell of a tandem cell. When the perovskite solar cell and a bottom cell with a textured structure are stacked together, it has become a key point of the tandem cell to improve hole transport performance of a hole transporting layer and thus improve a filling factor and conversion efficiency of the tandem cell. US2016/190377A1 discloses a photovoltaic device that has a photon receiving surface and a first single homojunction silicon solar cell. The first single homojunction silicon solar cell comprises two doped silicon portions with opposite polarities and has a first band gap. The photovoltaic device further comprises a second solar cell structure that has an absorber material with a perovskite structure and has a second band gap that is larger than the first band gap. The photovoltaic device is arranged such that each of the first and second solar cells absorb a portion of the photons that are received by the photon receiving surface. WO 2018/150203 A1 discloses a multi-junction photovoltaic device comprising a first sub-cell comprising a photoactive region comprising a layer of perovskite material, a second sub-cell comprising a photoactive silicon absorber and an intermediate region disposed between and connecting the first sub-cell and the second sub-cell. The intermediate region comprises an interconnect layer, the interconnect layer comprising a two-phase material comprising elongate (i.e. filament like) silicon nanocrystals embedded in a silicon oxide matrix. "Multilayer Cascade Charge Transport Layer for High-Performance Inverted Mesoscopic All-Inorganic and Hybrid Wide-Bandgap Perovskite Solar Cells" (Chen Yu et al) discloses that it is imperative to improve the quality of light absorber and reduce the charge-carrier recombination for efficient perovskite solar cells (PsCs). Herein, a synergistic regulation strategy that combines the tailoring of crystallinity and construction of multilayer cascade charge transport layers (CTLs) for inverted CsPbl, Br solar cells is presented. The film quality of CsPbl, Br is well tuned via F doping. In addition, gradient energy alignment between perovskite and CTLs,i.e., NiOx/Zn: CuGaO2/perovskite and perovskite/TiO2/PC61BM/ZnO, favors the charge transfer and depresses carrier recombination. Noticeably, the TiO2interlayer with deep valence band maximum effectively blocks the hole back-transfer from perovskite to PCsrBM. These unique characteristics of the novel structured CsPblzBr device give a champion power conversion efficiency (PCE) of15.10% along with good thermal and operational stability. Moreover, the graded CTLs can be expanded to methyl ammonium-free hybrid perovskite device (E_{g}=≈ 1.76eV) by delivering a PcE of 18.12%, showing great promise in tandem solar cells for use as top cell. CN 105679941A discloses a plane structure perovskite solar cell and a preparation method thereof. The cell comprises a hole transport layer and a light capture layer, wherein the light capture layer is prepared from an MXZ3-type perovskite material; M is selected from Cs<+>, CH₃NH₃<+>, CH₃CH₂NH₃<+>, CH(NH₂)₂<+> or a mixture thereof; X is selected from Pb<2+>, Sn<2+>, Ge<2+> or a mixture thereof; Z is selected from Cl<->, Br<->, I<-> or the mixture thereof; the hole transport layer is prepared from a doped or un-doped ADO2-type semiconductor material with a p-type delafossite structure; A is selected from Cu or Ag; D is selected from one or more of Cr, Ga, Sc, In, Y or Fe; and a doping element is selected from one or two of Mg, Ca, Sr or Ga. A film of the hole transport layer provided by the invention has good electrical conductivity, proper energy level position, high transmittance and low cost; a solar cell device with excellent and stable performance can be obtained; and propulsion of industrialization of the perovskite solar cell is facilitated. US 2018/151304 A1 discloses a multijunction photovoltaic device, including: a first subcell and a second subcell. The first cell includes a base semiconductor layer and a second semiconductor layer. The base semiconductor layer includes a Group III-V semi-conductor material. The second subcell includes an absorber layer. The absorber layer includes an organometallic halide ionic solid perovskite semiconductor material. "X-ray Spectroscopic Study of the Electronic Structure of CuCrO2" (Arnold T. et al) discloses that the electronic structure of the p-type transparent conducting oxide CuCrO₂ has been studied by x-ray photoemission, x-ray absorption, and x-ray emission spectroscopies. The upper part of the valence band derives mainly from Cu 3*d* and Cr 3*d* states while the lower valence-band states are of dominant O 2*p* atomic character, but with pronounced mutual hybridization among Cu 3*d,* Cr 3*d*, and O 2*p* states. Site specific electronic excitations have been studied by resonant inelastic x-ray scattering at the Cu L and Cr L edges. Inelastic loss at the Cu L edge is dominated by on-site inter band excitations similar to those found in Cu, O, while at the Cr Ledge localized excitations arising from ligand field splitting of the Cr 3d levels are observed. Mg doping on the Cr sites in CuCrO₂ is shown to lead to a pronounced shift in the Fermi level toward the edge of the valence band. The experimental data are compared to electronic structure calculations on CuCrO2 carried out using density-functional methods corrected for onsite Coulomb repulsion.

### SUMMARY

An object of the present disclosure is to provide a tandem cell as defined in the claims to improve hole transport performance of the tandem cell.

### BRIEF DESCRIPTION OF THE DRAWINGS

The figures described here are used to provide a further understanding of the application and constitute a part of the present application. The indicative embodiments and their explanations of the present application are used to explain the present application, which does not constitute an improper limitation of the present application. In the figures:
FIG. 1 is a schematic structural diagram of a tandem cell according to an embodiment of the present disclosure;
FIGs. 2a and 2b are schematic diagrams of crystal structures of a semiconductor material with a p-type delafossite structure according to an embodiment of the present disclosure, wherein a is the first crystal structure of the semiconductor material with the p-type delafossite structure, and b is the second crystal structure of the semiconductor material with the p-type delafossite structure;
FIG. 3 is a schematic structural diagram of an n-type silicon heterojunction-perovskite tandem cell according to an embodiment of the present disclosure;
FIG. 4 to FIG. 16 are schematic diagrams of various stages of a manufacturing process of the n-type silicon heterojunction-perovskite tandem cell according to an embodiment of the present disclosure;
FIG. 17a is a schematic front view of a front face of an n-type silicon heterojunction-perovskite tandem cell shown in FIG. 3;
FIG. 17b is a front view of a back face of an n-type silicon heterojunction-perovskite tandem cell shown in FIG. 3;
FIG. 18 is a SEM image of a surface morphology of the tandem cell prepared in Embodiment 1 of the present disclosure;
FIG. 19 is a cross-sectional SEM image of the tandem cell prepared in Embodiment 1 of the present disclosure;
FIG. 20 is an I-V curve of the tandem cells prepared in Embodiment 1, Comparative Embodiment 1 and Comparative Embodiment 2 of the present disclosure;
FIG. 21 is a schematic diagram of energy bands of tandem cells according to Comparative Embodiments 1 and 2; and
FIG. 22 is a schematic diagram of an energy band of a tandem cell according to an embodiment of the present disclosure.

Elements and reference numbers:
100-bottom cell, 101-n-type monocrystalline silicon substrate, 102-first passivation layer, 103-second passivation layer, 104-n-type doped layer, 105-p-type doped layer, 106-first transparent conducting layer, 210-passivation layer, 220-n-heavily doped layer, 310-hole transport layer, 320-perovskite absorbing layer, 331-electron transporting interface layer, 332-leakage repairing layer, 333-electron transporting layer, 340-transparent conducting layer, 341-second transparent conducting layer, 400-electrode.

### DETAILED DESCRIPTION OF THE EMBODIMENTS

In order to facilitate a clear description of the technical solution of the embodiments of the present application, in the embodiments of the present application, the words "first" and "second" etc. are used to distinguish the same items or similar items with basically the same functions and roles. A person skilled in the art can understand that the words "first" and "second" etc. do not limit the number and execution order, and the words "first" and "second" etc. are not limited to that they must be different.

In the description of the present application, it is necessary to understand that the orientation or positional relationship indicated by the terms "up", "down", "front", "back", "left", "right", etc. is based on the orientation or positional relationship shown in the figures. It is only to facilitate the description and simplify the description of the present application, rather than to indicate or imply that the device or component referred to must have a specific orientation, be constructed and operated in a specific orientation, so it cannot be understood as a limitation on the present application.

It should be noted that, in the present application, the words "illustrative" or "for example" etc. are used to mean giving examples, illustration or explanations. Any embodiment or designing solution described as "exemplar" or "for example" in the present application should not be interpreted as being more preferred or advantageous than other embodiments or designing solutions. Specifically, the use of words such as "exemplar" or "for example" etc. aims to present relevant concepts in a specific way.

In the present disclosure, "at least one" refers to one or more, and "multiple" refers to two or more. An expression "and/or" which describes a relationship of related objects means that there may be three relationships, for example, an expression "A and/or B" can refer to A alone, A and B, and B alone, where A and B may be in a singular or plural form. A character "/"generally indicates an "or" relationship for contextual objects. An expression "at least one of following ones (items)" or its similar expression refers to any combination of these items, including any combination of single one (item) or plural items (ones). For example, at least one of a, b or c can refer to: a, b, c, combination of a and b, combination of a and c, combination of b and c, or combination of a, b and c, where a, b and c may be in a singular or plural form.

At present, crystalline silicon cells, as a mainstream product in photovoltaic field, involve high-efficiency crystalline silicon photovoltaic cell technologies, with a cell efficiency (26.7%) close to its theoretical limit efficiency (29.4%). With continuous development of photovoltaic technologies, tandem cell technologies have been proved to be an effective way to break through an efficiency of a traditional crystalline silicon photovoltaic cell.

Organic-inorganic hybrid perovskite solar cells, as a new type of high-efficiency and low-cost solar cells, have been widely concerned all over the world. In just a few years, photoelectric conversion efficiency of perovskite cells has rapidly climbed from 3.8% in 2009 to over 25%, which is close to the efficiency of commercial silicon-based solar cells. The perovskite cell can adjust an absorption band gap of the perovskite cell ranging from 1.5 eV to 1.8 eV by adjusting composition formula, so that the perovskite cell may be an ideal tandem top cell. A crystalline silicon-perovskite tandem cell combined by the perovskite cell and the crystalline silicon cell is expected to achieve a photoelectric conversion efficiency of more than 30%. At present, it has been shown in documents that the conversion efficiency of the crystalline silicon-perovskite tandem cell can reach more than 25%.

The crystalline silicon-perovskite tandem cell uses the crystalline silicon cell as the bottom cell to absorb energy of sunlight with a wavelength of 800 nm-1200 nm, and uses the perovskite cell as the top cell to absorb energy of sunlight with a wavelength of 300 nm-800 nm. The bottom cell and the top cell are connected through the tunneling composite layer to form cells with two ends connected in series, and an overall open circuit voltage of the tandem cell is superposition of open circuit voltages of the top cell and the bottom cell.

Internal series connection between the bottom cell and the top cell needs to meet two conditions of reducing optical absorption and ohmic contact at the same time. In related art, a tunneling junction is generally disposed between the top cell and the bottom cell to enhance recombination of carriers, but a thickness, a growth quality and an impurity diffusion of the tunneling junction may greatly affect performance of the tunneling junction, with a harsh preparation condition. In addition, when the hole transporting layer of the top perovskite solar cell is made of organic materials, compatibility of the hole transporting layer with the tunneling junction and the perovskite layer is poor, and it is difficult to form a perovskite film with good crystallinity, which affects a filling factor and a conversion efficiency of the tandem cell.

In order to solve above technical problems, a tandem cell is further provided in an embodiment of The present disclosure. The tandem cell is not only suitable for a tandem cell with the crystalline silicon cell as the bottom cell, but also suitable for a tandem cell with any one of a polycrystalline silicon cell, an ingot monocrystalline silicon cell, a copper indium gallium selenide cell, a perovskite cell, a gallium arsenide cell and an organic photovoltaic cell as the bottom cell, which is not limited herein.

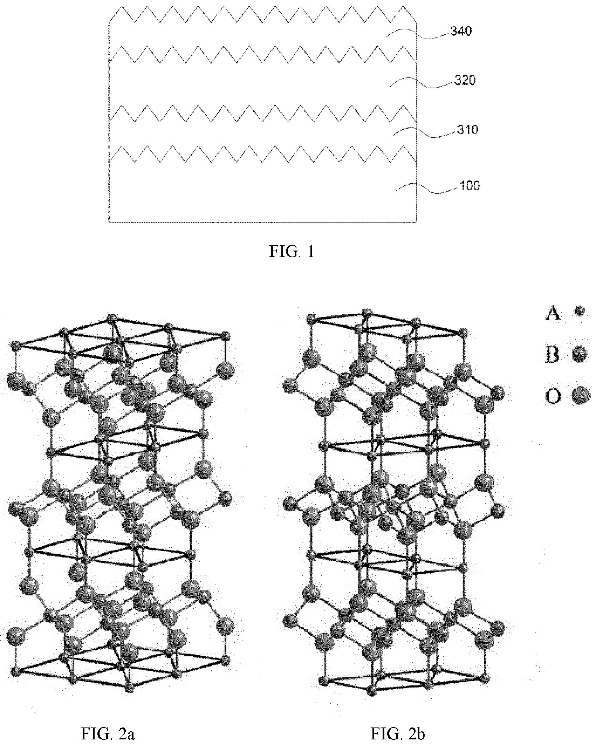

As shown in FIG. 1, the tandem cell according to an embodiment of the present disclosure includes a stacked bottom cell 100, a hole transporting layer 310, a perovskite absorbing layer 320 and a transparent conducting layer 340.

The bottom cell 100 has a textured surface. The bottom cell 100 may be any of the bottom cell 100 described above, which is not limited herein. The textured surface may be a pyramid-shaped textured surface or an inverted pyramid-shaped textured surface.

A passivation layer 210 may be formed on the bottom cell 100. A material of the passivation layer 210 includes silicon dioxide or the like. At this time, the passivation layer 210 may better play a role in passivating the bottom cell 100 and restraining adverse carrier recombination. In practical applications, the passivation layer 210 can also be omitted.

A top layer of the bottom cell 100 is an n-type heavily doped layer 220, which is located on the passivation layer 210 and is in contact with a hole transporting layer 310 described below. The n-type heavily doped layer 220 contacts with the hole transporting layer 310 to form a carrier recombination interface. The bottom cell 100 may be an n-type cell or a p-type cell. At this time, on the one hand, the n-type heavily doped layer 220, together with a passivation layer 210 and the bottom cell 100 below the n-type heavily doped layer 220, form a passive cell structure, which can passivate contacts, reduce adverse recombination of carriers and improve the photoelectric conversion efficiency of the bottom cell 100. On the other hand, a tunneling recombination interface is formed by the n-type heavily doped layer 220 and a surface of the hole transporting layer 310 close to the bottom cell 100, thus realizing tunneling recombination of carriers between the bottom cell 100 and the top cell. Specifically, the n-type heavily doped layer may be a microcrystalline silicon layer doped with a VA group atom such as phosphorus, arsenic, antimony and bismuth atom.

The hole transporting layer 310 is formed on the n-type heavily doped layer 220, and a valence band top energy level of the hole transporting layer 310 sequentially decreases in a direction away from the bottom cell 100. The valence band top energy level of the hole transporting layer 310 ranges from -4.5 eV to-5.4 eV.

In practical applications, a content of the element B in the hole transporting layer increases sequentially in a direction from a part of the hole transport further from the perovskite absorbing layer to a part of the hole transport closer to the perovskite absorbing layer; and the valence band top energy level of the hole transporting layer sequentially decreasing.

Specifically, elements contained in the hole transporting layer, as well as distribution and chemical ratio of the elements contained in the hole transporting layer, are adjusted so as to fabricate the hole transporting layer with a sequentially decreasing valence band top energy level.

In fabricating the hole transporting layer, specific elements of A, B and C in the semiconductor material AB_{α}Cₓ with a p-type delafossite structure and values of α and x are selected according to actual situations. Of course, it is also possible to control distribution of materials during a fabrication process, so as to fabricate the hole transporting layer with the sequentially decreasing valence band top energy level.

Specifically, three sub-layers of p-type delafossite films are deposited by sputtering, and each of the sub-layers uses a p-type delafossite target with different B contents. For example, a first sub-layer uses a target with a composition of AB_{0.9}O₂, a second sub-layer uses a target with a composition of ABO₂, and a third sub-layer uses a target with a composition of AB_{1.1}O₂. The first sub-layer is a first sub-layer in a direction away from the bottom cell and the second sub-layer is arranged on the first sub-layer in the direction away from the bottom cell. The third sub-layer is arranged on the second sub-layer in the direction away from the bottom cell, that is, B contents in the sub-layers increase sequentially in a direction from a layer further from the perovskite absorbing layer to a layer closer to the perovskite absorbing layer.

A material of the hole transporting layer 310 includes a semiconductor material with a p-type delafossite structure, and the perovskite absorbing layer 320 is formed on the hole transporting layer 310, and the perovskite absorbing layer 320 may be made of a semiconductor material with a perovskite structure.

In terms of the hole transporting layer 310 formed on the bottom cell 100, a material of the hole transporting layer 310 includes a semiconductor material with a p-type delafossite structure. At this time, from the perovskite absorbing layer 320 to the hole transporting layer 310 and to the bottom cell 100, energy levels between the three films sequentially vary, so that hole transport barrier may be reduced, charge loss may be reduced, and the hole transporting performance and the filling factor of the tandem cell may be further improved.

Meanwhile, in a direction away from the bottom cell 100, the valence band top energy level of the hole transporting layer 310 sequentially decreases. At this time, a valence band top energy level at a surface of the hole transporting layer 310 close to the bottom cell 100 is close to a conduction band energy level at a surface of the bottom cell 100, which can form a tunneling composite interface with the n-type heavily doped layer 220 on the bottom cell 100, thus omitting the tunneling composite layer of the tandem cell, simplifying a process of the tandem cell, reducing process difficulty. In addition, the energy band structure of the hole transporting layer 310 sequentially varies, which facilitate to driving transporting of hole carriers.

In addition, because the semiconductor material with the p-type delafossite structure is an inorganic semiconductor material, the hole transporting layer 310 made of the semiconductor material with the p-type delafossite structure have good compatibility with and adaptability to the n-type heavily doped layer 220 made of an inorganic material, which can improve various performance parameters and photoelectric conversion efficiency of the tandem cell. Moreover, compared with the hole transporting materials such as Spiro-OMeTAD or PTAA, which are expensive, complicated in synthesis and have poor stability after introducing dopants, manufacturing methods of the semiconductor material with the p-type delafossite structure are mature and low prices, which can greatly reduce manufacturing cost of the tandem cell.

The semiconductor material with the p-type delafossite structure is a p-type semiconductor material with high mobility. A general chemical formula of the semiconductor material with the p-type delafossite structure is AB_{α}Cₓ, wherein A is a monovalent soft acid cation, B is a trivalent cation and C is an oxygen group element. α ranges from 0.9 to 1.1 and x ranges from 1.95 to 2.6. For example, α may be 0.9, 1.0, 1.1; and x may be 1.95, 2.0, 2.05, 2.1, 2.14, 2.3, 2.4, 2.5 or 2.6. A general chemical formula of the semiconductor material with a perovskite structure is SDY₃. S is a monovalent organic cation, D is a divalent soft acid cation, and Y is a monovalent soft base anion.

According to an principle of easy and stable combination of soft acids and soft bases, on the one hand, there is a strong interaction force between Y ions contained in the perovskite absorbing layer 320 and A ions contained in the hole transporting layer 310, so that the hole transporting layer 310 containing A ions can induce crystal growth of perovskite materials thereon, and then it is easy to form the perovskite absorbing layer 320 with higher order and crystallinity, thus improving the photoelectric conversion efficiency. Meanwhile, at an interface between the hole transporting layer 310 and the perovskite absorbing layer 320, a soft acid cation of the semiconductor material with the p-type delafossite structure may perform soft-acid-soft-base coordinating with a Y ion (soft alkali ion) of the perovskite material, so that interface defects of the perovskite absorbing layer 320 may be passivated, carrier recombination of the tandem cell may be reduced, and the photoelectric conversion efficiency may be improved. In addition, due to a soft-acid-soft-base coordination force between the A ions and the Y ions in the perovskite absorbing layer 320, lattice matching at a contact interface between the hole transporting layer 310 and the perovskite absorbing layer 320 is high, so that hole extraction performance of the hole transporting layer 310 may be improved. On the other hand, there also is a strong interaction force between the Y ion contained in the perovskite absorbing layer 320 and the soft acid cation D, so that soft-acid-soft-base coordinating may be performed, so that a thin film with high crystallinity may be formed by the force between the two, and performance of the perovskite absorbing layer 320 to absorb sunlight and generate carriers may be improved, thereby improving the photoelectric conversion efficiency of the tandem cell.

In the semiconductor material with the p-type delafossite structure described above, A may include one or more of Cu⁺, Ag⁺, Pd⁺, Sr⁺ and Pt⁺, which often exists in a monovalent state. B may include one or more of B³⁺, Al³⁺, Ga³⁺, In³⁺, Cr³⁺, Fe³⁺, Sc³⁺and trivalent rare earth cations, which often exists in trivalent state, and α ranges from 0.9 to 1.1. C is an oxygen group element, including one or more of O, S, Se and Te, and x ranges from 1.95 to 2.6. Polarizability of these A ions is close to polarizability of Y ions in the perovskite material forming the perovskite absorbing layer 320, thus having strong coordination force, and further improving hole transporting capacity and photoelectric conversion efficiency of the tandem cell.

A space group for the crystal structure of the semiconductor material with the p-type delafossite structure is R3m (space group NO.166). As shown in FIG. 2a and FIG. 2b, when C is O element and x is 2, in its crystal structure, one B atom can form edge-sharing octa-coordination of BO₆ with six O atoms, and one A atom is linearly coordinated with two O atoms in an adjacent BO₆ layer, respectively, and A atoms constitute an A atom layer. The A atom layer and the BO₆ layer form an alternating crystal structure and are stacked through O-A-O ionic bonds. In the octacoordinated BO₆ structure, an ionic radius of the B atom may be varied in a range of 0.5 Å to 1 Å. It can be seen that the p-type delafossite structure has broad tolerance for B atoms, that is, there's a wide choice space for the B atoms. In view of different ionic radii of B atoms, optical, electrical and magnetic properties of the semiconductor material with the p-type delafossite structure are different, so that the optical, electrical and magnetic properties of the semiconductor material with the p-type delafossite structure may be regulated in a wide range. At this time, a band gap of the hole transporting layer 310 may be adjusted in a range from 1.3 eV to 3.5 eV through regulation in composition. Meanwhile, the band gap of the hole transporting layer 310 may be adjusted to be different from the band gaps of the perovskite absorbing layer 320 and the bottom cell 100, thereby avoiding absorption of solar energy in an absorptive band of the tandem cell by the hole transporting layer 310.

Taking AgGaO₂ as an example, its band gap is 3.1 eV, its valence band top energy level is -5.20 eV and its conduction band bottom energy level is -2.10 eV. On the one hand, the valence band top energy level of AgGaO₂ is close to a HOMO energy level (about -5.30 eV) of the perovskite absorbing layer 320, which facilitates collection of hole charges; on the other hand, its conduction band low energy level is far from a LUMO energy level (about -3.90 eV) of the perovskite absorbing layer 320, which can effectively block diffusion of electrons.

The hole transporting layer 310 may be doped with a metal or nonmetal element. The metal element may be Mg, and the nonmetal element may be N. At this time, a band gap width of the hole transporting layer 310 may be adjusted by a method of doping, which fabricates it easier for the hole transporting layer 310 to match the energy levels of the n-type heavily doped layer 220 and the perovskite absorbing layer 320.

For example, one or more of Mg, Ga and Sr may be doped in the semiconductor material with the p-type delafossite structure for fabricating the hole transporting layer 310. At this time, due to doping of the metal elements, the valence band top energy level of the hole transporting layer 310 varies slightly. For example, when Ga is doped in CuCrO₂, a material for fabricating the hole transporting layer 310, the valence band top energy level of the hole transporting layer 310 may decrease by 0.05 eV.

The hole transporting layer 310 may be formed on the n-type heavily doped layer 220 by a vacuum deposition process. The formed hole transporting layer 310 has a thickness from 5 nm to 100nm. For example, a thickness of the hole transporting layer 310 may be 5 nm, 18 nm, 20nm, 30 nm, 40 nm, 47 nm, 50 nm, 60nm, 70 nm, 77 nm, 85nm, 90nm, 95 nm or 100 nm, etc.

When the hole transporting layer 310 is formed of the semiconductor material with the p-type delafossite structure by vacuum deposition, pollution of impurities to the semiconductor material with the p-type delafossite structure may be reduced, and then the hole transporting layer 310 with high crystallinity, high purity, good compactness and good bonding strength may be formed, thereby further improving a hole transporting efficiency of the hole transporting layer 310 and its bonding performance with the n-type heavily doped layer 220, and increasing the filling factor and photoelectric conversion efficiency of the tandem cell.

In the semiconductor material SDY₃ with a perovskite structure contained in the perovskite absorbing layer 320, S is one or more of CH₃NH₃ cation, C₄H₉NH₃ cation, NH₂ = CHNH₂ cation and Cs cation; D is one of or a combination of two of Pb²⁺ and Sn²⁺; Y is one or more of I⁻, Cl⁻and Br⁻. The perovskite absorbing layer 320 may be fabricated by firstly co-evaporating to form a cation anchoring layer, and then spin-coating an anion salt and then annealing.

The transparent conducting layer 340 is formed above the perovskite absorbing layer 320. Of course, an electron transporting layer 333 may be included between the perovskite absorbing layer 320 and the transparent conducting layer 340, and an electrode 400 is further formed on the transparent conducting layer 340 and the bottom cell 100.

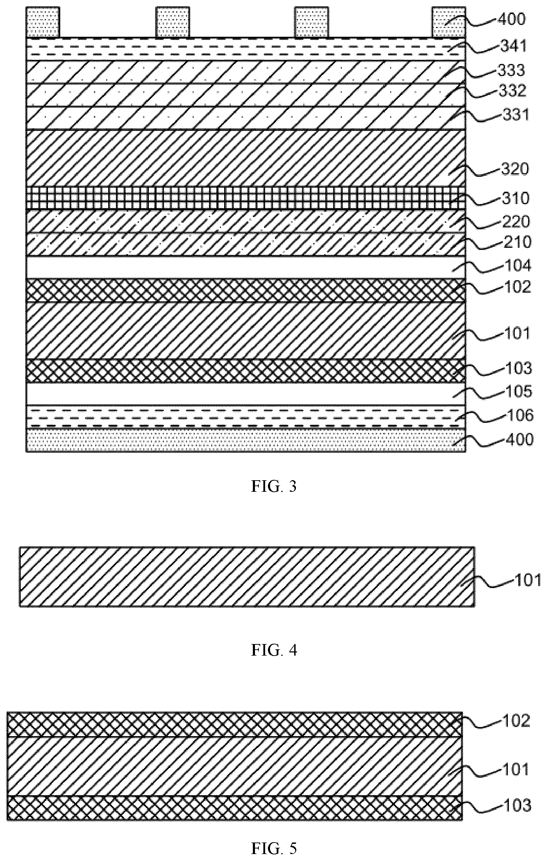

A manufacturing method of a tandem cell is further provided in an embodiment of the present disclosure. Taking manufacturing of the n-type silicon heterojunction-perovskite tandem cell shown in FIG. 3 as an example, the manufacturing method is as follows.

As shown in FIG. 4, an n-type crystalline silicon wafer is provided. The n-type crystalline silicon wafer may be a commercial M2 silicon wafer with resistivity of 1 Ω.cm to 10 Ω.cm and a thickness from 50 µm to 200 µm. The n-type crystalline silicon wafer is polished, textured and cleaned in turn to form the n-type monocrystalline silicon substrate 101 with a textured surface.

As shown in FIG. 5, an intrinsic amorphous silicon passivation layer is deposited on both sides of the n-type monocrystalline silicon substrate 101 to form a first passivation layer 102 on a front face of the n-type monocrystalline silicon substrate 101 and a second passivation layer 103 on a back face of the n-type monocrystalline silicon substrate 101. In practical applications, a plasma chemical vapor deposition (PECVD) process, a hot filament chemical vapor deposition process or a catalytic chemical vapor deposition process may be used to fabricate the intrinsic amorphous silicon passivation layer. A thickness of the intrinsic amorphous silicon passivation layer may be from 1 nm to 20 nm.

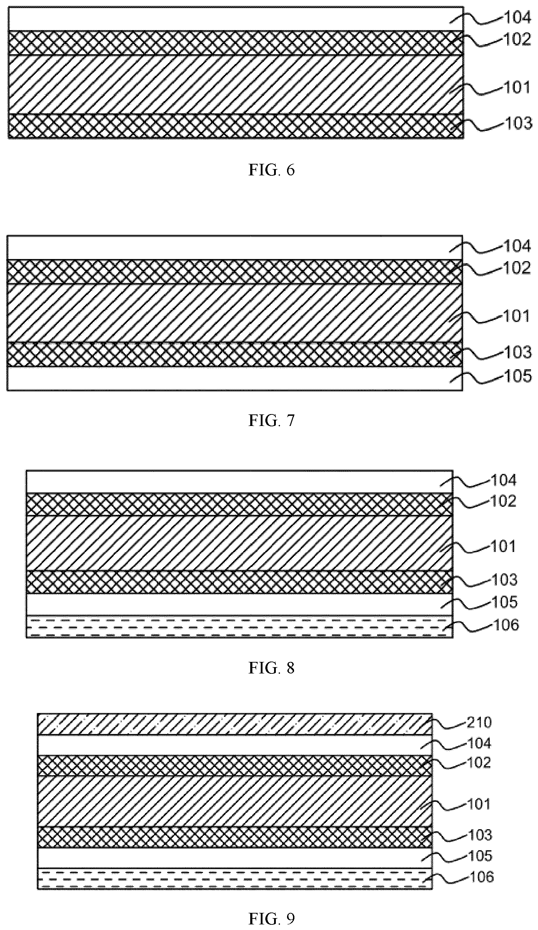

As shown in FIG. 6, an n-type doped layer 104 is deposited on the first passivation layer 102 to form a front field structure. The n-type doped layer 104 is made of amorphous silicon or microcrystalline silicon. In practical applications, the n-type doped layer 104 may be fabricated by a PECVD process, a hot filament chemical vapor deposition process or a catalytic chemical vapor deposition process. A thickness of the n-type doped layer 104 may be from 1 nm to 30 nm.

As shown in FIG. 7, a p-type doped layer 105 is deposited on the second passivation layer 103 to form a back emitter. The p-type doped layer is made of amorphous silicon or microcrystalline silicon. In practical applications, the p-type doped layer 105 may be made by a PECVD process, a hot filament chemical vapor deposition process or a catalytic chemical vapor deposition process. A thickness of the p-type doped layer 105 may be from 1 nm to 30 nm.

As shown in FIG. 8, a first transparent conducting layer 106 is formed on the p-type doped layer 105 to realize collection and transmission of photo-generated carriers. In practical applications, the first transparent conducting layer 106 may be manufactured by a magnetron sputtering process. Specifically, a material of the first transparent conducting layer 106 may be one or more of indium tin oxide (ITO), tungsten-doped indium oxide (In₂O₃: W, abbreviated as IWO), indium zinc oxide (IZO) and titanium-doped indium oxide thin film (ITiO). A thickness of the first transparent conducting layer 106 may be from 30 nm to 120 nm. The obtained structure is defined as the bottom cell 100, which has a textured surface.

It should be understood that as a starting step of the tandem cell, the cell may be fabricated by providing an n-type crystalline silicon wafer as a process starting point, or the tandem cell may be fabricated by taking the bottom cell 100 defined in the present disclosure as the process starting point.

As shown in FIG. 9, a passivation layer 210 is formed on the n-type doped layer 104 to realize contact passivation. In practical applications, the passivation layer 210 may be fabricated by magnetron sputtering, chemical vapor deposition and other processes.

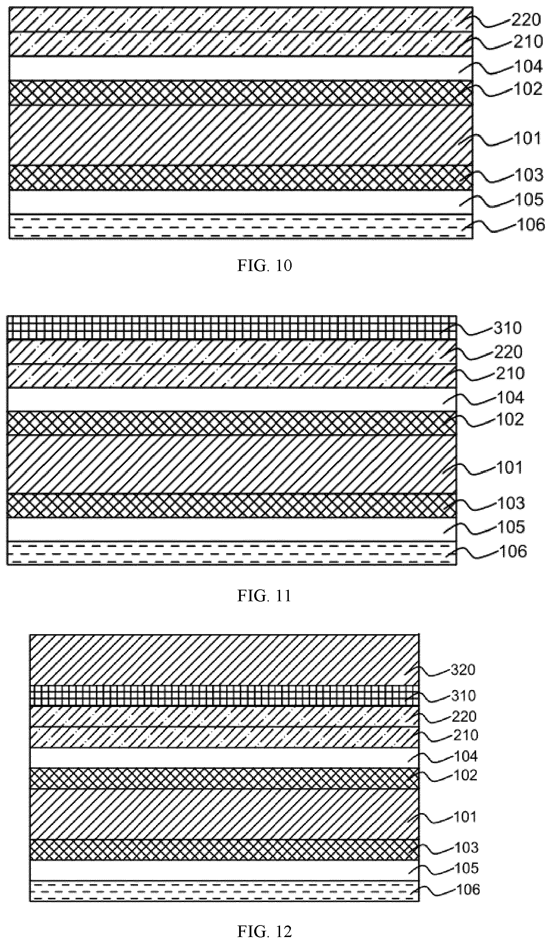

As shown in FIG. 10, an n-type heavily doped layer 220 is formed on the silicon passivation layer 210. The n-type heavily doped layer and a surface of the hole transporting layer 310 close to the bottom cell 100 below constitute a tunneling composite interface to realize tunneling composite collection of photo-generated carriers. Illustratively, the n-type heavily doped layer 220 may be a phosphorus-doped microcrystalline silicon thin film. The n-type doped layer 220 may be fabricated by a PECVD process, a hot filament chemical vapor deposition process or a catalytic chemical vapor deposition process.

As shown in FIG. 11, a hole transporting layer 310 of the semiconductor material with the p-type delafossite structure is formed on the n-type heavily doped layer 220. In a direction away from the bottom cell 100, the valence band top energy level of the hole transporting layer 310 sequentially decreases, with a variation range of the valence band top energy level from -4.5 eV to -5.4 eV. In practical applications, the hole transporting layer 310 may be manufactured by a vacuum deposition process. Specifically, the vacuum deposition process may be a magnetron sputtering process, a laser pulse deposition process or a thermal evaporation coating process.

For example, when the hole transporting layer 310 is manufactured by the magnetron sputtering process, a hole transporting layer with a thickness from 5 nm to 100 nm is formed.

As shown in FIG. 12, a perovskite absorbing layer 320 is formed on the hole transporting layer 310. Specifically,

Lead iodide and cesium bromide are formed on the hole transporting layer 310 by co-evaporation, with a total thickness of 250 nm-1000 nm.

A mixed solution of formamidine hydroiodide (FAI) and formamidine hydrobromide (FABr) is coated on lead iodide and cesium bromide, and the mixed solution of FAI and FABr may be reacted with lead iodide and cesium bromide to form a perovskite material film. A molar concentration ratio of FAI and FABr may be (2-4):1, and a solvent of the mixed solution of FAI and FABr may be ethanol or isopropanol.

The perovskite material thin film is annealed to form the perovskite absorbing layer 320. An annealing temperature may be from 100°C to 200°C, with annealing time from 5 min to 30 min, and a thickness of the perovskite absorbing layer 320 may be from 100 nm to 1000 nm. A material composition of the perovskite absorbing layer 320 is CsₓFA₁₋ₓPb(Br_{y}I_{1-y})₃.

When the perovskite absorbing layer 320 is fabricated by the above methods, the cationic salt quickly reacts with underlying lead iodide to form the perovskite thin film and excessive unreacted cationic salt solution is thrown off a processing interface with a spin coating process, thus avoiding accumulation at a valley bottom of the pyramid-shaped textured surface, so that a uniform perovskite thin film may be conformally deposited on the textured surface.

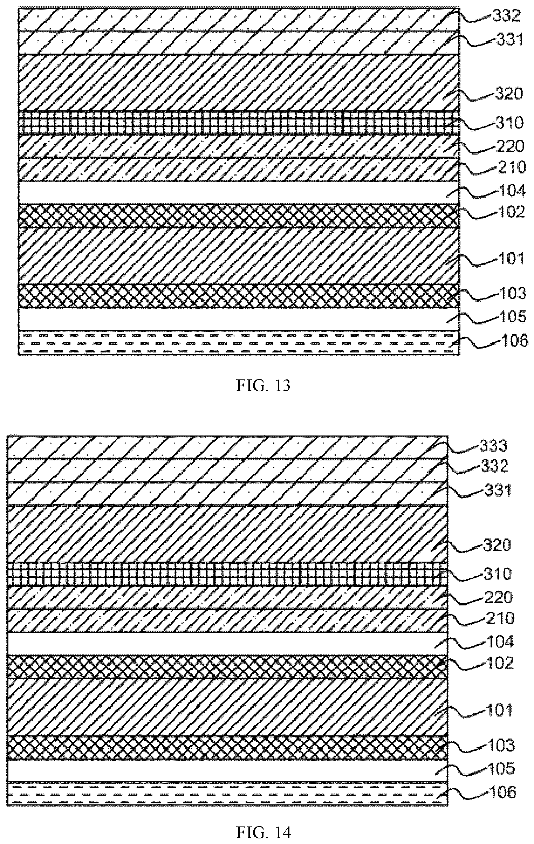

As shown in FIG. 13, an electron transporting interface layer 331 and a leakage repairing layer 332 are sequentially formed on the perovskite absorbing layer 320. In practical applications, the electron transporting interface layer 331 may be a LiF thin film layer, and the leakage repairing layer 332 may be a C60 or fullerene derivative (PCBM) thin film layer. The LiF thin film layer and C60 thin film layer may be fabricated by thermal evaporation, a thickness of the electron transporting interface layer 331 may be from 0.1 nm to 10 nm, and a thickness of the leakage repairing layer 332 may be from 1 nm to 20 nm. In practical applications, one or both of the electron transporting interface layer 331 and the leakage repairing layer 332 may be omitted.

As shown in FIG. 14, an electron transporting layer 333 is formed on the electron transporting interface layer 331. In practical applications, the electron transporting layer 333 may be made of SnO₂ with a layer thickness from 1 nm to 30 nm, and its manufacturing process may be any one of atomic layer deposition (ALD) process, chemical vapor deposition process, physical vapor deposition process and solution coating process.

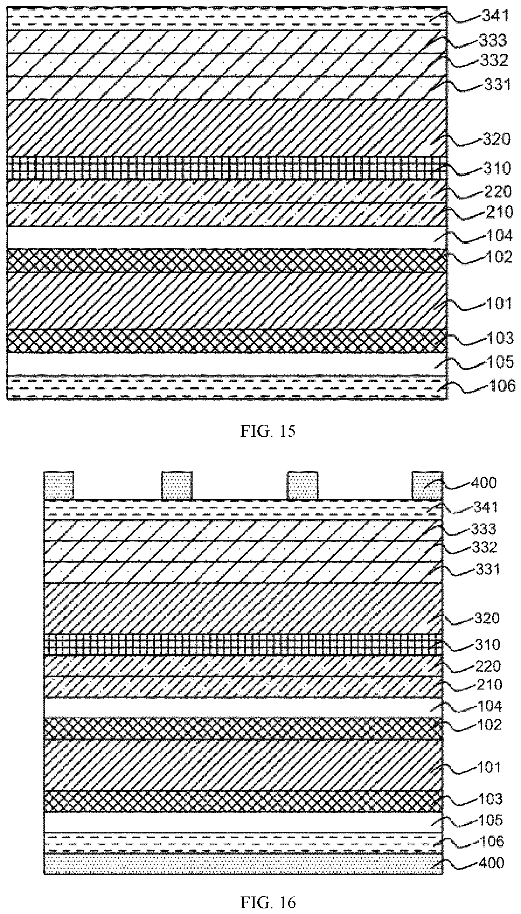

As shown in FIG. 15, a second transparent conducting layer 341 is formed on the electron transporting layer 333 to collect photo-generated carriers. A material, a thickness and a formation process of the second transparent conducting layer 341 may refer to the first transparent conducting layer 106.

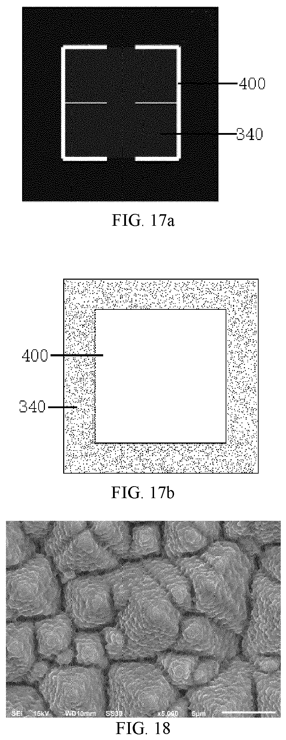

As shown in FIG. 16, an electrode 400 is formed on the first transparent conducting layer 106 and the second transparent conducting layer 341 to collect current. In practical applications, grid lines of the electrode 400 may be fabricated by silk-screen printing or mask evaporating. A thickness of the electrode 400 may be from 100 nm to 500 nm, and the electrode 400 may be made of silver, copper, aluminum and other metals with good electrical conductivity. FIG. 17a is a schematic front view of an n-type silicon heterojunction-perovskite tandem cell shown; FIG. 17b is a front view of a back face of an n-type silicon heterojunction-perovskite tandem cell. As shown in FIG. 17a and FIG. 17b, the electrode 400 is formed on the first transparent conducting layer 106 and the second transparent conducting layer 341.

In order to verify performance of the tandem cell manufactured by the manufacturing method of the tandem cell according to the embodiment of the present disclosure, following description is made by comparing the embodiments and comparative embodiments with each other.

### Embodiment 1

The manufacturing method of the n-type silicon heterojunction-perovskite tandem cell according to the embodiment of the present disclosure is specifically as follows.

In step 1, an n-type M2 silicon wafer with a resistivity of 4 Ω.cm and a thickness of 180 µm is provided. The silicon wafer is polished, textured and cleaned to form an n-type monocrystalline silicon substrate with a textured surface.

In step 2, an intrinsic amorphous silicon passivation layer (with a thickness of 5 nm) is deposited on both sides of the n-type monocrystalline silicon substrate by a PECVD device to form a first passivation layer on a front face of the n-type monocrystalline silicon substrate and a second passivation layer on a back face of the n-type monocrystalline silicon substrate.

In step 3, an n-type amorphous silicon layer (with a thickness of 10 nm) doped with phosphorus (with a doping concentration of 10²⁰ cm⁻³) is deposited on the first passivation layer by the PECVD device so as to form a front field structure.

In step 4, a p-type amorphous silicon layer (with a thickness of 10 nm) doped with boron (with a doping concentration of 10¹⁹ cm⁻³) is deposited on the second passivation layer by the PECVD device so as to form a back field emitter.

In step 5, the first transparent conducting layer (with a thickness of 100 nm) made of ITO is prepared on the p-type amorphous silicon layer by the magnetron sputtering process.

In step 6, a passivation layer is formed on the n-type amorphous silicon layer by the magnetron sputtering process.

In step 7, a phosphorus-doped n-type heavily doped layer is formed on the passivation layer by the PECVD device.

In step 8, a hole transporting layer made of AgGaₓO₂ is prepared on the n-type heavily doped layer by magnetron sputtering. Three layers of composite hole transport material are prepared by using three kinds of AgGaₓO₂ targets with different compositions. Specifically, a first layer is made of a target with composition of AgGa_{0.9}O₂, a second layer is made of a target with composition of AgGaO₂ and a third layer is made of a target with composition of AgGa_{1.1}O₂. A thickness of each hole transporting layer is 5 nm, and a total thickness of the hole transporting layer is 15 nm.

In step 9, lead iodide and cesium bromide are formed on the hole transporting layer by co-evaporation, with a total thickness of 350 nm.

A mixed solution of FAI and FABr is prepared, with a molar concentration ratio of FAI and FABr of 3:1 and a solvent of ethanol. A 100 µL mixed solution of FAI and FABr is spin-coated on a layer of lead iodide and cesium bromide and react to form the perovskite material film.

At a temperature of 150°C, the perovskite thin film is annealed for 30 min, and a dense and uniform perovskite absorbing layer (with a thickness of 500 nm) is formed. A component of the absorption layer is CsₓFA₁₋ₓPb(Br_{y}I_{1-y})₃.

In step 10, the LiF thin film layer (with a thickness of 1 nm) and a C60 thin film layer (with a thickness of 10 nm) are formed on the perovskite absorbing layer by thermal evaporation.

In step 11, the electron transporting layer (with a thickness of 10 nm) made of SnO₂ is fabricated by atomic layer deposition (ALD) process.

In step 12, a second transparent conducting layer (with a thickness of 100 nm) made of ITO is formed on the electron transporting layer by the magnetron sputtering process.

In step 13, silver electrode grid lines are formed on the first transparent conducting layer and the second transparent conducting layer by using a silk-screen printing process.

### Embodiment 2

The manufacturing method of the n-type silicon heterojunction-perovskite tandem cell according to the embodiment of the present disclosure is specifically as follows.

In step 1, an n-type silicon wafer with a resistivity of 1 Ω cm and a thickness of 50 µm is provided. The silicon wafer is polished, textured and cleaned to form an n-type monocrystalline silicon substrate with a textured surface.

In step 2, an intrinsic amorphous silicon passivation layer (with a thickness of 1 nm) is deposited on both sides of the n-type monocrystalline silicon substrate by a PECVD device to form a first passivation layer on a front face of the n-type monocrystalline silicon substrate and a second passivation layer on a back face of the n-type monocrystalline silicon substrate.

In step 3, an n-type amorphous silicon layer (with a thickness of 1 nm) doped with phosphorus (with a doping concentration of 10²⁰ cm⁻³) is deposited on the first passivation layer by the PECVD device so as to form a front field structure.

In step 4, a p-type amorphous silicon layer (with a thickness of 1 nm) doped with boron (with a doping concentration of 10¹⁹ cm⁻³) is deposited on the second passivation layer by the PECVD device so as to form a back field emitter.

In step 5, the first transparent conducting layer (with a thickness of 30 nm) made of ITO is prepared on the p-type amorphous silicon layer by the magnetron sputtering process.

In step 6, a passivation layer is formed on the n-type amorphous silicon layer by the magnetron sputtering process.

In step 7, a phosphorus-doped n-type heavily doped layer is formed on the passivation layer by the PECVD device.

In step 8, a hole transporting layer made of AgCrₓO₂ is prepared on the n-type heavily doped layer by a laser pulse deposition process. Three layers of composite hole transport material are prepared by using three kinds of AgCrₓO₂ targets with different compositions. Specifically, a first layer is made of a target with composition of AgCr_{0.95}O₂, a second layer is made of a target with composition of AgCrO₂ and a third layer is made of a target with composition of AgCr_{1.05}O₂. A thickness of each hole transporting layer is 5 nm, and a total thickness of the hole transporting layer is 15 nm. In a direction away from the bottom cell, the valence band top energy level of the hole transporting layer sequentially decreases, with a variation range of the valence band top energy level from -4.5 eV to -5.4 eV.

In step 9, lead iodide and cesium bromide are formed on the hole transporting layer by co-evaporation, with a total thickness of 250 nm.

A mixed solution of FAI and FABr is prepared, with a molar concentration ratio of FAI and FABr of 2:1 and a solvent of ethanol. A 100 µL mixed solution of FAI and FABr is spin-coated on a layer of lead iodide and cesium bromide and react to form the perovskite material film.

At a temperature of 100°C, the perovskite thin film is annealed for 5 min, and a dense and uniform perovskite absorbing layer (with a thickness of 100 nm) is formed. A component of the absorption layer is CsₓFA₁₋ₓPb(Br_{y}I_{1-y})₃.

In step 10, the LiF thin film layer (with a thickness of 0.1 nm) and a C60 thin film layer (with a thickness of 1 nm) are formed on the perovskite absorbing layer by thermal evaporation.

In step 11, the electron transporting layer (with a thickness of 1 nm) made of SnO₂ is fabricated by atomic layer deposition (ALD) process.

In step 12, a second transparent conducting layer made of ITO (with a thickness of 30 nm) is formed on the electron transporting layer by the magnetron sputtering process.

In step 13, silver electrode grid lines are formed on the first transparent conducting layer and the second transparent conducting layer by using a silk-screen printing process.

### Embodiment 3

The manufacturing method of the n-type silicon heterojunction-perovskite tandem cell according to the embodiment of the present disclosure is specifically as follows.

In step 1, an n-type silicon wafer with a resistivity of 10 Ω cm and a thickness of 200 µm is provided. The silicon wafer is polished, textured and cleaned to form an n-type monocrystalline silicon substrate with a textured surface.

In step 2, an intrinsic amorphous silicon passivation layer (with a thickness of 20 nm) is deposited on both sides of the n-type monocrystalline silicon substrate by PECVD device to form a first passivation layer on a front face of the n-type monocrystalline silicon substrate and a second passivation layer on a back face of the n-type monocrystalline silicon substrate.

In step 3, an n-type amorphous silicon layer (with a thickness of 30 nm) doped with phosphorus (with a doping concentration of 10²⁰ cm⁻³) is deposited on the first passivation layer by the PECVD device so as to form a front field structure.

In step 4, a p-type amorphous silicon layer (with a thickness of 30 nm) doped with boron (with a doping concentration of 10¹⁹ cm⁻³) is deposited on the second passivation layer by the PECVD device so as to form a back field emitter.

In step 5, the first transparent conducting layer (with a thickness of 120 nm) made of ITO is prepared on the p-type amorphous silicon layer by the magnetron sputtering process.

In step 6, a passivation layer is formed on the n-type amorphous silicon layer by the magnetron sputtering process.

In step 7, a phosphorus-doped n-type heavily doped layer is formed on the passivation layer by the PECVD device.

In step 8, a hole transporting layer made of AgGaₓO₂ is prepared on the n-type heavily doped layer by a laser pulse deposition process. Three layers of composite hole transport material are prepared by using three kinds of AgGaₓO₂ targets with different compositions. Specifically, a first layer is made of a target with composition of AgGa_{0.95}O₂, a second layer is made of a target with composition of AgGaO₂ and a third layer is made of a target with composition of AgGa_{1.05}O₂. A thickness of each hole transporting layer is 25 nm, and a total thickness of the hole transporting layer is 75 nm. In a direction away from the bottom cell, the valence band top energy level of the hole transporting layer sequentially decreases, with a variation range of the valence band top energy level from -4.5 eV to -5.4 eV.

In step 9, lead iodide and cesium bromide are formed on the hole transporting layer by co-evaporation, with a total thickness of 1000 nm.

A mixed solution of FAI and FABr is prepared, with a molar concentration ratio of FAI and FABr of 4:1 and a solvent of ethanol. A 100 µL mixed solution of FAI and FABr is spin-coated on a layer of lead iodide and cesium bromide and react to form the perovskite material film.

At a temperature of 200°C, the perovskite thin film is annealed for 30 min, and a dense and uniform perovskite absorbing layer (with a thickness of 1000 nm) is formed. A component of the absorption layer is CsₓFA₁₋ₓPb(BryI_{1-y})₃.

In step 10, the LiF thin film layer (with a thickness of 10 nm) and a C60 thin film layer (with a thickness of 20 nm) are formed on the perovskite absorbing layer by thermal evaporation.

In step 11, the electron transporting layer (with a thickness of 30 nm) made of SnO₂ is fabricated by atomic layer deposition (ALD) process.

In step 12, a second transparent conducting layer (with a thickness of 120 nm) made of ITO is formed on the electron transporting layer by the magnetron sputtering process.

In step 13, silver electrode grid lines are formed on the first transparent conducting layer and the second transparent conducting layer by using a silk-screen printing process.

### Comparative Embodiment 1

A manufacturing method of a tandem cell according to this comparative example is basically the same as that described in the Embodiment 1 above, with only difference that the hole transporting layer is made of Spiro-TTB, and a manufacturing process of the hole transporting layer is a thermal evaporation process. The valence band top energy level is the same everywhere in the hole transporting layer, and there is a p-type heavily doped layer between the passivation layer and the hole transporting layer.

### Comparative Embodiment 2

A manufacturing method of a tandem cell according to this comparative example is basically the same as that described in the Embodiment 1 above, with only difference that the hole transporting layer is made of nickel oxide. The valence band top energy level is the same everywhere in the hole transporting layer, and there is a p-type heavily doped layer between the passivation layer and the hole transporting layer.

In order to verify performance of the tandem cell, scanning electron microscope (SEM) and I-V tests are performed on devices prepared in Embodiment 1, Comparative Embodiment 1 and Comparative Embodiment 2, and performance parameters such as a photoelectric conversion efficiency, a filling factor, an open-circuit voltage and a short-circuit current of the devices are compared (Table 1).

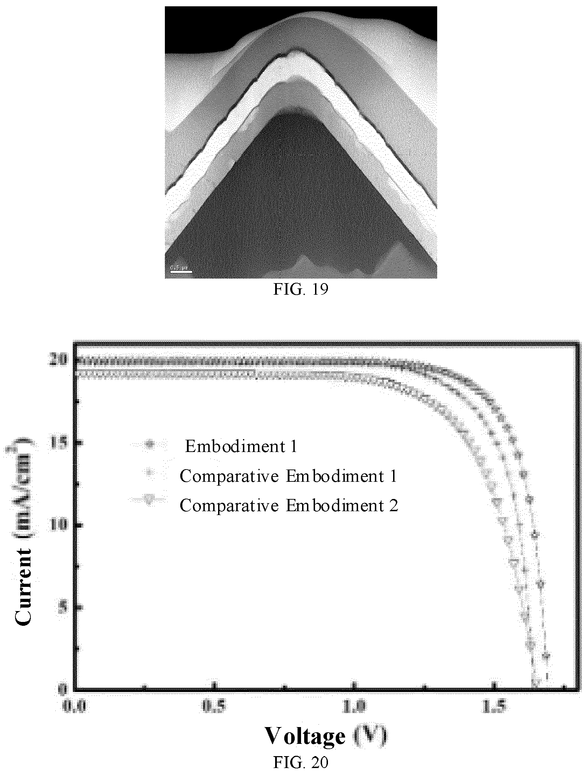

FIG. 18 shows a SEM image of surface morphology of the tandem cell prepared in Embodiment 1. FIG. 19 shows a SEM image of a cross section of the tandem cell prepared in Embodiment 1. As can be seen from FIG. 18, a surface of the tandem cell prepared in Embodiment 1 is a pyramid textured surface. It can be seen from FIG. 19 that a lower surface of the perovskite absorbing layer is closely attached to the hole transporting layer, and no defect at a tip of the pyramid or accumulation at valleys between pyramids is observed. In addition, no interfacial void and peeling phenomenon were observed in the perovskite absorbing layer, and the perovskite thin film grew evenly, and no obvious grain boundary defects are observed, which indicates that crystallinity of the perovskite absorbing layer is high. It can be seen that functional layers of the top cell of the tandem cell prepared in Embodiment 1 may be distributed along the pyramid textured surface of the bottom cell, and interface contact between the hole transporting layer and the perovskite absorbing layer is good, and film forming quality of the perovskite absorbing layer is good.

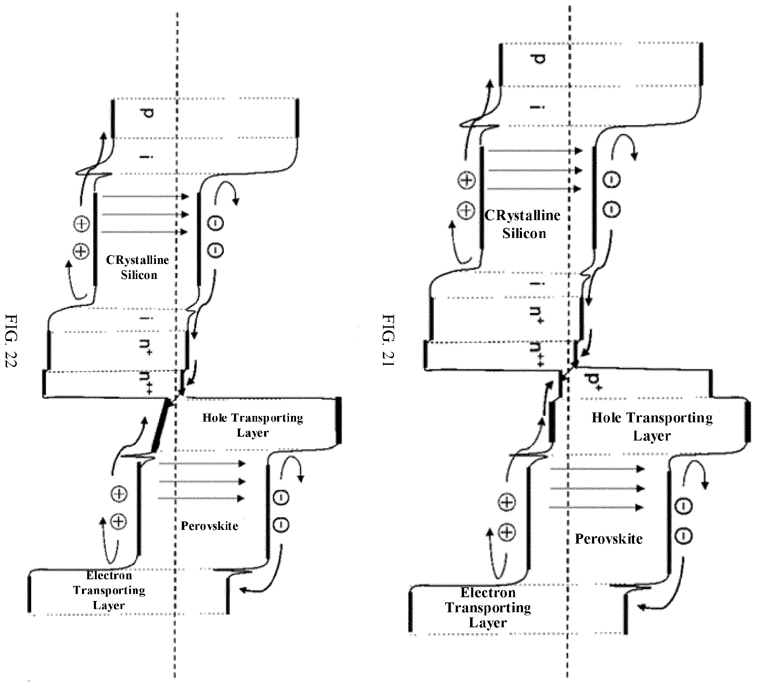

FIG. 20 shows I-V curves of the tandem cells prepared in Embodiment 1, Comparative Embodiment 1 and Comparative Embodiment 2 under irradiation of AM1.5G solar intensity. As can be seen from FIG. 20, a short-circuit current J_{sc} of the tandem cell prepared in Embodiment 1 is 20.2 mA/cm², an open-circuit voltage V_{oc} is 1.69 V, a filling factor FF is 77%, and a final cell conversion efficiency is 26.3%. FIG. 21 is a schematic diagram showing energy bands of tandem cells according to Comparative Embodiments 1 and 2. FIG. 22 is a schematic diagram showing energy bands of the tandem cells of Embodiments 1 to 3. Comparing FIG. 21 with FIG. 22, it can be seen that the hole transporting layer with the sequentially decreasing valence band top energy level is used to replace the p-type heavily doped layer (with the p-type heavily doped layer omitted), the valence band top energy level of the hole transporting layer is close to a valence band energy level of the perovskite absorbing layer, and the conduction band low energy level of the hole transporting layer is close to a conduction band energy level of the n-type heavily doped layer, so that a contact barrier is small, a hole transport efficiency may be improved, and a carrier recombination efficiency is high.

The device performance parameters of the tandem cell prepared in Embodiment 1 are obviously superior to those of traditional tandem cells. Table 1 shows performance parameters of tandem cells prepared in various embodiments and comparative embodiments.

**Table 1 Comparison table of performance parameters of different tandem cells**

| Number | Effective Area (cm²) | V_{OC} (V) | J_{SC} (mA/cm² ) | FF | Photoelectric Conversion Efficiency |
|---|---|---|---|---|---|
| Embodiment 1 | 1.21 | 1.69 | 20.2 | 0.77 | 26.3% |
| Embodiment 2 | 1.21 | 1.62 | 19.3 | 0.78 | 24.4% |
| Embodiment 3 | 1.21 | 1.67 | 20.2 | 0.76 | 26.2% |
| Comparative Embodiment 1 | 1.21 | 1.64 | 19.9 | 0.75 | 24.5% |
| Comparative Embodiment 2 | 1.21 | 1.65 | 19.2 | 0.70 | 22.2% |

As can be seen from FIG. 20 and Table 1, a short-circuit current J_{sc} of the tandem cell prepared in Embodiment 1 is 20.2 mA/cm², an open-circuit voltage V_{oc} is 1.69 V, a filling factor FF is 77%, and a final cell conversion efficiency is 26.3%. The device performance parameters of the tandem cell prepared in Embodiment 1 are obviously superior to those of traditional tandem cells in Comparative Embodiment 1 and Comparative Embodiment 2. Compared with Embodiment 1 and Embodiment 2, it can be seen that the filling factor of the tandem cell may be finely adjusted by adjusting a material of the hole transporting layer. By comparing Embodiment 1 and Embodiment 3, it can be seen that better performance of a tandem cell may be obtained by using different vacuum deposition processes.

## Claims

1. A tandem cell, comprising:
a bottom cell (100);
a hole transporting layer (310) formed on the bottom cell (100),
a perovskite absorbing layer (320) formed on the hole transporting layer (310); and
a transparent conducting layer (340) formed above the perovskite absorbing layer (320);
**characterized in that** a material of the hole transporting layer (310) comprises a semiconductor material with a p-type delafossite structure,
a general chemical formula of the semiconductor material with the p-type delafossite structure is AB_{α}Cₓ, wherein A comprises one or more of Cu⁺, Ag⁺, Pd⁺, Sr⁺ and Pt⁺, and B comprises one or more of B³⁺, Al³⁺, Ga³⁺ , In³⁺, Cr³⁺, Fe³⁺, Sc³⁺ and trivalent rare earth cations; C is an oxygen group element, comprising one or more of O, S, Se and Te; x ranges from 1.95 to 2.6; and α ranges from 0.9 to 1.1; and
a content of the element B in the hole transporting layer (310) sequentially increases sequentially in a direction from a part of the hole transport further from the perovskite absorbing layer (320) to a part of the hole transport closer to the perovskite absorbing layer (320) such that a valence band top energy level of the hole transporting layer (310) sequentially decreases in a direction away from the bottom cell (100).

2. The tandem cell according to claim 1, wherein a thickness of the hole transporting layer (310) is from 5 nm to 100 nm.

3. The tandem cell according to claim 1 or 2, wherein a top layer of the bottom cell (100) is an n-type heavily doped layer (220), and the n-type heavily doped layer (220) contacts with the hole transporting layer (310) to form a carrier recombination interface.

4. The tandem cell according to claim 3, wherein the tandem cell further comprises a passivation layer (210) between the bottom cell (100) and the n-type heavily doped layer (220).

5. The tandem cell according to claim 1 or 2, wherein the bottom cell (100) is any one of a crystalline silicon bottom cell, a polycrystalline silicon bottom cell, an ingot monocrystalline silicon bottom cell, a copper indium gallium selenide bottom cell, a perovskite bottom cell, a gallium arsenide bottom cell and an organic photovoltaic bottom cell.

6. A method for manufacturing the tandem cell according to any one of claims 1 to 5, comprising:
providing the bottom cell (100);
forming the hole transporting layer (310) on the bottom cell (100) by a vacuum deposition process, a material of the hole transporting layer (310) comprising the semiconductor material with the p-type delafossite structure, and the valence band top energy level of the hole transporting layer (310) sequentially decreasing in the direction away from the bottom cell (100);
forming the perovskite absorbing layer (320) on the hole transporting layer (310); and
forming an electron transporting layer and a transparent conducting layer (340) on the perovskite absorbing layer (320).

## Patentansprüche

1. Tandemzelle, umfassend:
eine untere Zelle (100);
eine Lochtransportschicht (310), die auf der unteren Zelle (100) gebildet ist;
eine Perowskit-Absorberschicht (320), die auf der Lochtransportschicht (310) gebildet ist;
und
eine transparente leitende Schicht (340), die über der Perowskit-Absorberschicht (320) gebildet ist;
**dadurch gekennzeichnet, dass** ein Material der Lochtransportschicht (310) ein Halbleitermaterial mit einer p-Typ-Delafossit-Struktur umfasst;
eine allgemeine chemische Formel des Halbleitermaterials mit der p-Typ-Delafossit-Struktur AB_{α}Cₓ ist, wobei A eine oder mehrere von Cu⁺, Ag⁺, Pd⁺, Sr⁺ und Pt⁺ umfasst und B eine oder mehrere von B³⁺, Al³⁺, Ga³⁺, In³⁺, Cr³⁺, Fe³⁺, Sc³⁺ und trivalenten Seltenerdmetallkationen umfasst; C ein Sauerstoff-Gruppenelement ist, umfassend eine oder mehrere von O, S, Se und Te; x von 1,95 bis 2,6 reicht und α von 0,9 bis 1,1 reicht; und
ein Inhalt des Elements B in der Lochtransportschicht (310) sequenziell in einer Richtung von einem Teil des Lochtransports weiter entfernt von der Perowskit-Absorberschicht (320) zu einem Teil des Lochtransports näher hin zu der Perowskit-Absorberschicht (320) sequenziell zunimmt, so dass ein Valenzband-Spitzenenergieniveau der Lochtransportschicht (310) sequenziell in einer Richtung von der unteren Zelle (100) weg abnimmt.

2. Tandemzelle nach Anspruch 1, wobei eine Dicke der Lochtransportschicht (310) von 5 nm bis 100 nm beträgt.

3. Tandemzelle nach Anspruch 1 oder 2, wobei eine obere Schicht der unteren Zelle (100) eine stark dotierte n-Typ-Schicht (220) ist und die stark dotierte n-Typ-Schicht (220) die Lochtransportschicht (310) berührt, um eine Trägerrekombinationsgrenzfläche zu bilden.

4. Tandemzelle nach Anspruch 3, wobei die Tandemzelle ferner eine Passivierungsschicht (210) zwischen der unteren Zelle (100) und der stark dotierten n-Typ-Schicht (220) umfasst.

5. Tandemzelle nach Anspruch 1 oder 2, wobei die untere Zelle (100) eine beliebige von einer unteren Zelle aus kristallinem Silizium, einer unteren Zelle aus polykristallinem Silizium, einer unteren Zelle aus monokristallinem Silizium-Ingot, einer unteren Zelle aus Kupfer-Indium-Gallium-Selenid, einer unteren Zelle aus Perowskit, einer unteren Zelle aus Galliumarsenid und einer unteren organischen Photovoltaikzelle ist.

6. Verfahren zur Herstellung der Tandemzelle nach einem der Ansprüche 1 bis 5, umfassend:
Bereitstellen der unteren Zelle (100);
Bilden der Lochtransportschicht (310) auf der unteren Zelle (100) durch einen Vakuumabscheidungsprozess, wobei ein Material der Lochtransportschicht (310) das Halbleitermaterial mit der p-Typ-Delafossit-Struktur umfasst und das Valenzband-Spitzenenergieniveau der Lochtransportschicht (310) sequenziell in der Richtung von der unteren Zelle (100) weg abnimmt;
Bilden der Perowskit-Absorberschicht (320) auf der Lochtransportschicht (310); und
Bilden einer Elektronentransportschicht und einer transparenten leitenden Schicht (340) auf der Perowskit-Absorberschicht (320).

## Revendications

1. Cellule tandem, comprenant :
une cellule inférieure (100) ;
une couche de transport de trous (310) formée sur la cellule inférieure (100),
une couche d'absorption en pérovskite (320) formée sur la couche de transport de trous (310) ; et
une couche conductrice transparente (340) formée au-dessus de la couche d'absorption en pérovskite (320) ;
**caractérisée en ce qu'**un matériau de la couche de transport de trous (310) comprend un matériau semi-conducteur doté d'une structure de delafossite de type p,
une formule chimique générale du matériau semi-conducteur doté de la structure de delafossite de type p est ABαCₓ, dans laquelle A comprend l'un ou plusieurs parmi Cu⁺, Ag⁺, Pd⁺, Sr⁺ et Pt⁺, et B comprend l'un ou plusieurs parmi B³⁺, Al³⁺, Ga³⁺, In³⁺, Cr³⁺, Fe³⁺, Sc³⁺ et des cations trivalents des terres rares ; C est un élément du groupe de l'oxygène, comprenant l'un ou plusieurs parmi O, S, Se et Te ; x varie de 1,95 à 2,6 ; et α varie de 0,9 à 1,1 ; et
une teneur de l'élément B dans la couche de transport de trous (310) augmente en séquence dans une direction allant d'une partie du transport de trous plus loin de la couche d'absorption en pérovskite (320) à une partie du transport de trous plus proche de la couche d'absorption en pérovskite (320) de sorte qu'un niveau d'énergie supérieur de bande de valence de la couche de transport de trous (310) diminue en séquence dans une direction s'éloignant de la cellule inférieure (100).

2. Cellule tandem selon la revendication 1, dans laquelle une épaisseur de la couche de transport de trous (310) est de 5 nm à 100 nm.

3. Cellule tandem selon la revendication 1 ou 2, dans laquelle une couche supérieure de la cellule inférieure (100) est une couche fortement dopée de type n (220), et la couche fortement dopée de type n (220) est en contact avec la couche de transport de trous (310) pour former une interface de recombinaison de porteurs.

4. Cellule tandem selon la revendication 3, dans laquelle la cellule tandem comprend en outre une couche de passivation (210) entre la cellule inférieure (100) et la couche fortement dopée de type n (220).

5. Cellule tandem selon la revendication 1 ou 2, dans laquelle la cellule inférieure (100) est l'une quelconque parmi une cellule inférieure en silicium cristallin, une cellule inférieure en silicium polycristallin, une cellule inférieure en lingot de silicium monocristallin, une cellule inférieure en séléniure de cuivre-indium-gallium, une cellule inférieure en pérovskite, une cellule inférieure en arséniure de gallium et une cellule inférieure photovoltaïque organique.

6. Procédé de fabrication de la cellule tandem selon l'une quelconque des revendications 1 à 5, comprenant :
la fourniture de la cellule inférieure (100) ;
la formation de la couche de transport de trous (310) sur la cellule inférieure (100) par un processus de dépôt sous vide, un matériau de la couche de transport de trous (310) comprenant le matériau semi-conducteur doté de la structure de delafossite de type p, et le niveau d'énergie supérieur de bande de valence de la couche de transport de trous (310) diminuant en séquence dans la direction s'éloignant de la cellule inférieure (100) ;
la formation de la couche d'absorption en pérovskite (320) sur la couche de transport de trous (310) ; et
la formation d'une couche de transport d'électrons et d'une couche conductrice transparente (340) sur la couche d'absorption en pérovskite (320).
